# EUROPEAN PATENT APPLICATION

(11) **EP 2 023 354 A2**
(43) Date of publication of application: **11.02.2009**
(21) Application number: 08157235.6
(22) Date of filing: 29.05.2008
(51) Int. Cl.: H01F 10/00, H01F 10/32

(54) **Magnetoresistive element with a biasing layer**

(30) Priority: 01.08.2007 US 832416
(71) Applicant: Honeywell International Inc., Morristown NJ 07960 (US)
(72) Inventor: Katti, Romney R., Shorewood, MN 55331 (US)
(74) Representative: Buckley, Guy Julian

(57) **Abstract**

An improved magnetoresistive element may include a pinned magnetic structure, a free magnetic structure, and a spacer layer coupled between the pinned magnetic structure and the free magnetic structure, where the free magnetic structure includes (i) a synthetic anti-ferromagnetic structure (SAF) including two or more anti-ferromagnetically coupled ferromagnetic layers, and (ii) a first biasing layer coupled to the SAF that impedes a decoupling of the two or more anti-ferromagnetically coupled ferromagnetic layers. The first biasing layer may be an anti-ferromagnetic layer, and may be weakly coupled to the SAF. The free magnetic structure may also include (i) a second biasing layer coupled to the SAF that further impedes a decoupling of the two or more anti-ferromagnetically coupled ferromagnetic layers, and/or (ii) a non-magnetic layer coupled between the first biasing layer and the SAF that controls a coupling strength between the first biasing layer and the SAF.

## Description

### GOVERNMENT RIGHTS

The United States Government has acquired certain rights in this invention pursuant to Contract No. N00030-06-C-0003/SC001-0000000064/D50497 awarded by the United States Navy Strategic Systems Program/Trident.

### FIELD

The invention relates to magnetoresistive elements and more particularly to magnetoresistive elements for use in a magnetic random access memory (MRAM).

### BACKGROUND

MRAM is a non-volatile memory technology that is gaining popularity in the computer market. Unlike other memory technologies (e.g., SRAM, DRAM, FLASH, etc.) that store data as electric charge or current flows, MRAM stores data as a magnetic state in magnetoresistive storage elements (i.e., an MRAM cell). Typically, an MRAM cell includes two magnetic structures, each of which can hold a magnetic field that has one of two possible polarities. One example of an MRAM cell is a magnetic tunnel junction (MJT), which includes a free magnetic structure for data storage and a pinned magnetic structure for reference, separated by a nonmagnetic insulating barrier layer.

Preferably, the possible polarities of the magnetic structures in the MRAM cell will run either parallel or anti-parallel to an easy axis of the MRAM cell. The logic state of the MRAM cell may then depend on the polarity of the magnetic structures. For example, if the magnetic structures have the same polarity, the MRAM cell may be storing a "0." Alternatively, if the magnetic structures have an opposite polarity, the MRAM cell may be storing a "1." A device may determine the logic state of the MRAM cell by passing a sensing current through the MRAM cell and then measuring an electrical resistance of the cell, which relates to the polarity of the magnetic structures. In this respect, a higher resistance Rₘₐₓ typically indicates that the magnetic structures have an opposite polarity, whereas a lower resistance Rₘᵢₙ typically indicates that the magnetic structures have the same polarity.

A device may change a polarity of a free magnetic structure, and thus write data to an MRAM cell, by applying magnetic fields that couple to the free magnetic structure of the MRAM cell. This write process may depend on (i) a magnitude and direction of the applied magnetic field and (ii) a magnitude of a magnetic field required to switch the free magnetic structure (i.e., the "switching field" of the free magnetic structure). For example, the device cannot change the polarity of a free magnetic structure if the magnitude of the applied magnetic field does not exceed the switching field of the free magnetic structure. As another example, the device cannot change the polarity of the free magnetic structure if the direction of the applied magnetic field matches the polarity of the free magnetic structure. As such, the device may only be able to change the polarity of the free magnetic structure, and thus write data to the MRAM cell, if the direction of the applied magnetic field opposes the polarity of the free magnetic structure and the magnitude of the applied magnetic field exceeds the switching field of the free magnetic structure.

The magnetic fields described above may be created by bi- or unidirectional currents running through current lines arranged adjacent an MRAM cell. For example, an MRAM may include word lines arranged in one direction and bit lines that are arranged in a second direction that is perpendicular to the first direction. Using this configuration, the MRAM may selectively write data to a single MRAM cell by activating one word line and one bit line, thus generating a composite magnetic field at an MRAM cell located at an intersection of the word line and the bit line.

Recently, a modification to the MRAM cell described above, and the write process associated with the MRAM cell, has also emerged. The new MRAM cell may use a synthetic anti-ferromagnet (SAF) as the free magnetic structure, which includes a plurality of ferromagnetic free layers that are anti-ferromagnetically coupled. *See*, *for example*, U.S. Pat. No. 6,531,723. According to this configuration, in the absence of an applied magnetic field, each ferromagnetic free layer may have a magnetic moment vector that is anti-parallel from magnetic moment vectors in adjacent ferromagnetic free layers. The MRAM cell with the SAF free magnetic structure may then be written using the "toggle writing" method as described in U.S. Pat. No. 6,545,906. Advantageously, the new MRAM cell and write method may improve the selectivity of an MRAM by reducing the possibility that an MRAM cell will be switched by either a word line current or a bit line current on its own.

The toggle write method relies on a "switching" phenomenon and uses a timed switching pulse sequence of applied magnetic fields from the word line and/or the bit line to change a polarity of the SAF free magnetic structure. For example, at a time t₀, the toggle write method does not apply a word line magnetic current or a bit line current, thus resulting in a zero composite magnetic field at the free magnetic structure. At a time t₁, the toggle write method may activate the word line current, which may cause the magnetic moment vectors of the ferromagnetic free layers to begin rotating in a direction of a magnetic field generated by the word line current. At this time, the anti-ferromagnetic coupling of the ferromagnetic free layers may begin to decouple.

At a time t₂, the toggle write method may then activate the bit line current, which may create a composite magnetic field at a 45° angle with respect to the word and bit lines. In turn, that composite magnetic field may cause the magnetic moment vectors of the ferromagnetic free layers to continue rotating in the same direction as the rotation at time t₁, resulting in the magnetic moment vectors being nominally orthogonal to the composite magnetic field.

At a time t₃, the toggle write method may deactivate the word line current, which may result in the magnetic moment vectors of the ferromagnetic free layers being rotated only by the bit line magnetic field. At this point in time, the toggle write method may have rotated the magnetic moment vectors past their hard axis instability points. Finally, at a time t₄, the toggle write method may deactivate the bit line current, thus resulting in a zero composite magnetic field. At this time, the magnetic moment vectors of the ferromagnetic free layers may align along the preferred anisotropy axis (easy axis) in a 180° angle rotated state as compared to the initial state. Accordingly, the toggle write method has changed the polarity of the free magnetic structure, and has thus written data to the MRAM cell.

In order to successfully switch an MRAM cell with an SAF free magnetic structure, the magnetic fields generated by the current lines must be larger than the switching field, which is the magnetic field at which the anti-ferromagnetic coupling between the ferromagnetic free layers begins to decouple and magnetization of the ferromagnetic free layers begin to switch. In this respect, if the magnetic field does not reach the switching field, the SAF free magnetic structure may not change polarities. Further, the magnetic fields generated by the current lines must be smaller than the saturation field, which is the field at which the anti-ferromagnetic coupling between ferromagnetic free layers is entirely nullified and the magnetizations of the ferromagnetic layers become parallel. In this respect, if the magnetic field exceeds the saturation field and the magnetizations of the ferromagnetic layers become parallel, the SAF free magnetic structure becomes instable and write errors may occur. Accordingly, the switching field and the saturation field define an operating window for the SAF free magnetic structure in a magnetoresistive element, and it would be advantageous to maximize this operating window.

### SUMMARY

An improved magnetoresistive element that may be used as an MRAM cell is described.

One example of the present invention may take the form of an improved magnetoresistive element. The magnetoresistive element may include (A) a pinned magnetic structure, (B) a free magnetic structure, and (C) a spacer layer coupled between the pinned magnetic structure and the free magnetic structure, where the free magnetic structure then includes (1) a synthetic anti-ferromagnetic structure (SAF) including two or more anti-ferromagnetically coupled ferromagnetic layers, and (2) a first biasing layer coupled to the SAF that impedes a decoupling of the two or more anti-ferromagnetically coupled ferromagnetic layers of the SAF.

The first biasing layer may be an anti-ferromagnetic layer, such as an iron manganese layer, a nickel manganese layer, or a platinum manganese layer. Further, the first biasing layer may be weakly coupled to the SAF. For example, a coupling strength between the first biasing layer and the SAF may be less than an anti-ferromagnetic coupling strength of the SAF.

The free magnetic structure may also include a second biasing layer coupled to the SAF that further impedes a decoupling of the two or more anti-ferromagnetically coupled ferromagnetic layers. Further, the free magnetic structure may include a non-magnetic layer coupled between the first biasing layer and the SAF that controls a coupling strength between the first biasing layer and the SAF.

The SAF in the free magnetic structure may include (a) a first free ferromagnetic layer having a first magnetic moment vector, (b) a second free ferromagnetic layer having a second magnetic moment vector, and (c) an exchange layer coupled between the first free ferromagnetic layer and the second free ferromagnetic layer, where the first free ferromagnetic layer and the second free ferromagnetic layer are anti-ferromagnetically coupled through the exchange layer. In this example, the first biasing layer may be coupled to the first free ferromagnetic layer, and may then impede a rotation of the first magnetic moment vector. Further, the free magnetic structure may include a second biasing layer coupled to the second free ferromagnetic layer that impedes a rotation of the second magnetic moment vector. Further yet, the free magnetic structure may include a non-magnetic layer coupled between the first biasing layer and the first free ferromagnetic layer that controls a coupling strength between the first biasing layer and the first free ferromagnetic layer.

The spacer layer of the magnetoresistive element may be an insulating barrier that forms a magnetoresistive tunneling junction between the pinned magnetic structure and the free magnetic structure. Further, the pinned magnetic structure of the magnetoresistive element may include (1) a ferromagnetic structure having a magnetic moment vector and (2) an anti-ferromagnetic structure that pins the magnetic moment vector. In this respect, the ferromagnetic structure may be a SAF.

Another example of the present invention may take the form of a magnetic random access memory (MRAM). The MRAM may include (A) a word line arranged in a first direction, (B) a bit line arranged in a second direction perpendicular to the first direction, and (C) an MRAM cell positioned at an intersection of the word line and the bit line, where the MRAM cell is the magnetoresistive element described above. In this example, the word line may be arranged adjacent to and above the MRAM cell, and the bit line may be arranged adjacent to and below the MRAM cell. Further, the MRAM cell may include a first insulative space between the word line and the MRAM cell and a second insulative spacer between the bit line and the MRAM cell.

These as well as other aspects and advantages will become apparent to those of ordinary skill in the art by reading the following detailed description, with reference where appropriate to the accompanying drawings. Further, it is understood that this summary is merely an example and is not intended to limit the scope of the invention as claimed.

### BRIEF DESCRIPTION OF THE DRAWINGS

Figure 1 is sectional view of a magnetoresistive element, according to an example of the present invention;
Figure 2 is a sectional view of a first exemplary embodiment of the free layer structure of the magnetoresistive element of Figure 1;
Figure 3 is a sectional view of a second exemplary embodiment of the free layer structure of the magnetoresistive element of Figure 1;
Figure 4 is a sectional view of a third exemplary embodiment of the free layer structure of the magnetoresistive element of Figure 1; and
Figure 5 is a sectional view of a magnetic random access memory (MRAM), according to an example of the present invention.

### DETAILED DESCRIPTION

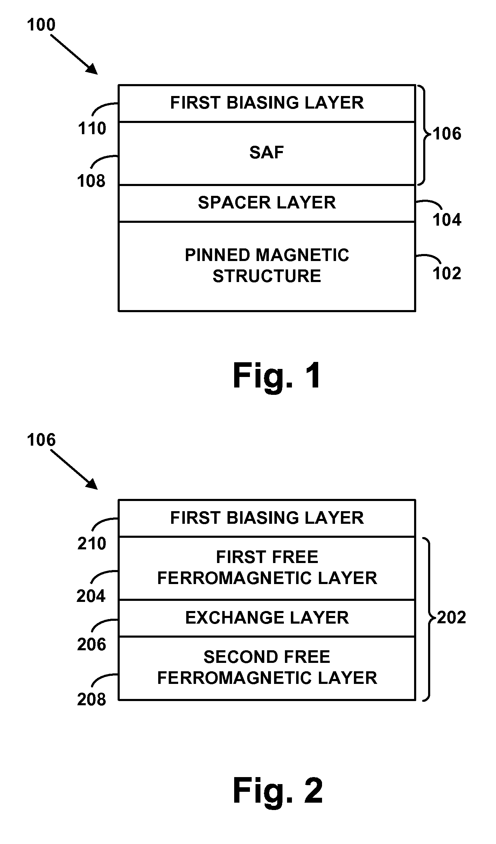

Referring to the drawings, Figure 1 is a sectional view of a magnetoresistive element 100, according to an example of the present invention. As shown, the magnetoresistive element 100 may include a pinned magnetic structure 102, a spacer layer 104, and a free magnetic structure 106. As shown, spacer layer 104 may be coupled between the pinned magnetic structure 102 and the free magnetic structure 106, such that the pinned magnetic structure 102 is coupled to a first side of the spacer layer 104 and the free magnetic structure 106 is coupled to a second side of the spacer layer 104.

The pinned magnetic structure 102 may include a ferromagnetic structure having a magnetic moment vector and an anti-ferromagnetic structure to fix the magnetic moment vector to a known polarity. As an example, the pinned magnetic structure 102 may include a ferromagnetic layer of Nickel Iron Cobalt (NiFeCo) with a thickness of approximately 2 nm and an anti-ferromagnetic layer of Iron Manganese (FeMn) with a thickness of approximately 5-10 nm. Further, the ferromagnetic and/or anti-ferromagnetic strcutures of the pinned magnetic structure 102 may be multi-layer structures as opposed to single layer structures. For example, the ferromagnetic structure of the pinned magnetic structure 102 may be a multi-layer synthetic anti-ferromagnet structure (SAF), such as the SAFs described below with reference to the free magnetic structure 106. Other examples are possible as well.

The spacer layer 104 may be a non-magnetic layer that separates the pinned magnetic structure 102 and the free magnetic structure 106. For example, the spacer layer 104 may be an electrically insulating layer that is sufficiently thin to allow tunneling of charge carriers between the pinned magnetic structure 102 and the free magnetic structure 106, thus forming a magnetic tunnel junction (MTJ) between the pinned magnetic structure 102 and the free magnetic structure 106. In this respect, the spacer layer may be a layer of dielectric material such as Aluminum Oxide (Al₂Ox₃) or Aluminum Nitride (AINi). Alternatively, the spacer layer 104 may be an electrically conductive layer that forms a spin valve structure. In this respect, the spacer layer 104 may be a layer of copper (Cu). Other examples are possible as well.

As shown, the free layer structure 106 will preferably include an SAF 108, which may include two or more ferromagnetic layers that are anti-ferromagnetically coupled. Further, the free layer structure 106 will preferably include at least one biasing layer 110 coupled to the SAF 108, which may be located on either side of the SAF 108. The at least one biasing layer 110 may impede a decoupling of the anti-ferromagnetic coupling of the SAF 108, such as by impeding a magnetic rotation of at least one ferromagnetic layer of the SAF 108. Further, the at least one biasing layer 110 may be weakly coupled to the SAF 108, such that the biasing layer 110 does not significantly alter a switching field of the SAF 108. For example, the coupling strength between the biasing layer 110 and the SAF 108 may be less than the anti-ferromagnetic coupling strength of the SAF 108. In this respect, the coupling strength between the biasing layer 110 and the SAF 108 may be 1/10 of the anti-ferromagnetic coupling strength of the SAF 108. This coupling strength may be controlled by the material, processing, and/or dimensions of the biasing layer 110 and the SAF 108.

For example, the biasing layer 110 may be an anti-ferromagnetic layer, such as an FeMn layer, a Nickel Manganese (NiMn) layer, and/or a Platinum Manganese (PtMn) layer. As another example, the biasing layer 110 may be an anti-ferrimagnetic layer, such as an Iron Oxide (FeO) layer. Further, the at least one biasing layer 110 may have a thickness between 10 Å and 500 Å. Thus, as one of many examples, the at least one biasing layer 110 may be a FeMn layer with a thickness of 50 Å.

Advantageously, the addition of the at least one biasing layer 110 to the free magnetic structure 106 may increase the saturation field of the SAF 108, and thus extend the operating window of the free magnetic structure 106. Further, the addition of the biasing layer 110 to the free magnetic structure 106 may increase the temperature range of the free magnetic structure 106 by compensating for temperature coefficient effects during the toggle write process. In either case, the free magnetic structure 106 with the biasing layer 110 may then increased write process stability at extreme currents and/or temperatures. Other advantages may exist as well.

Figure 2 is a sectional view of a first exemplary embodiment of the free layer structure 106 of the magnetoresistive element 100 of Figure 1. As shown, the first exemplary free layer structure 106 may include a tri-layer SAF 202 that consists of a first free ferromagnetic layer 204, an exchange layer 206, and a second free ferromagnetic layer 208. As shown, the exchange layer 206 may be coupled between the first and second free ferromagnetic layers, such that the first free ferromagnetic layer 204 is coupled to a first side of the exchange layer 206 and the second free ferromagnetic layer 208 is coupled to a second side of the exchange layer 206.

The first free ferromagnetic layer 204 and the second free ferromagnetic layer 208 may consist of various ferromagnetic materials, including alloys of cobalt (Co), iron (Fe), Nickel (Ni), and/or combinations thereof. Further, the first free ferromagnetic layer 204 and the second free ferromagnetic layer 208 may have various dimensions, depending on the design of the SAF 202. As one possible example, the first and second free ferromagnetic layers may be Nickel Iron Cobalt (NiFeCo) layers with a thickness of approximately 1 nm. The first free ferromagnetic layer 204 may have a first magnetic moment vector and the second free ferromagnetic layer 208 may have a second magnetic moment vector, each of which is free to rotate under application of a magnetic field. In turn, the SAF 202 may have a resultant magnetic moment vector based on the difference between the first and second magnetic moment vectors.

The exchange layer 206 may be any non-magnetic layer that anti-ferromagnetically couples the first free ferromagnetic layer 204 and the second free ferromagnetic layer 208, thus causing an anti-parallel orientation between the free ferromagnetic layers of the SAF 202 in the absence of an applied magnetic field. As such, the exchange layer 206 may consist of various materials, including ruthenium, osmium, rhenium, chromium, rhodium, copper, and/or combinations thereof. Further, the exchange layer 206 may have various dimensions, depending on the design of the SAF 202. As one possible example, the exchange layer may be a layer of ruthenium (Ru) with a thickness of 1 nm.

The first exemplary free layer structure 106 may then include a biasing layer 210, which may be substantially similar to the biasing layer 110. As shown, the biasing layer 210 may be coupled to the first free ferromagnetic layer 204 of the SAF 202. Alternatively, however, the biasing layer 210 may be coupled to the second free ferromagnetic layer 208 of the SAF 202. The biasing layer 210 may then impede a rotation of the first magnetic moment vector of the first free ferromagnetic layer 204. In turn, the biasing layer 210 may impede a decoupling of the anti-ferromagnetic coupling between the free ferromagnetic layers of the SAF 202, thus extending the saturation field of the first exemplary free magnetic structure 106.

Further, the biasing layer 210 will preferably be weakly coupled to the first free ferromagnetic layer 204, such that the biasing layer 210 does not significantly alter the switching field of the first free ferromagnetic layer 204, and thus the switching field of the SAF 202. In a preferred example, the coupling strength between the biasing layer 210 and the first free ferromagnetic layer 204 will be less than the anti-ferromagnetic coupling strength of the SAF 202 between the first free ferromagnetic layer 204 and the second free ferromagnetic layer 208. This coupling strength may be controlled by the material, processing, and/or dimensions of the biasing layer 210 and the SAF 202.

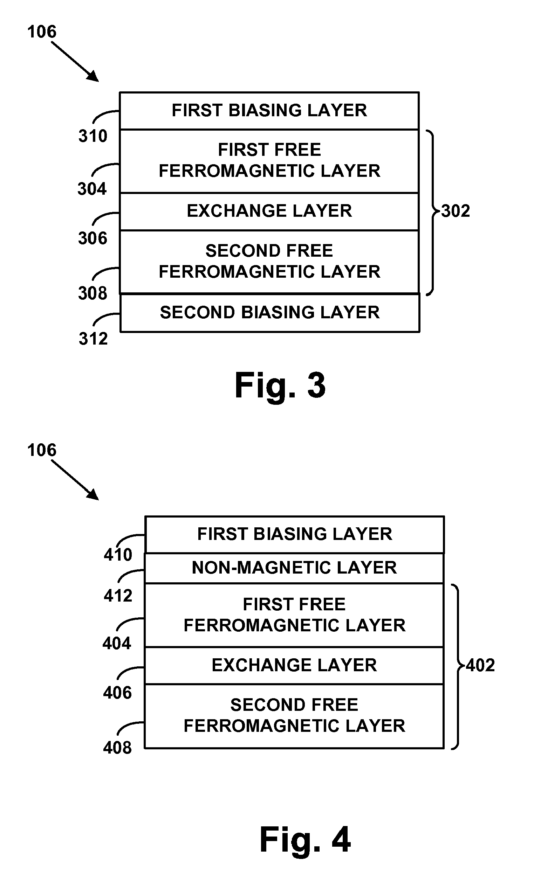

Figure 3 is a sectional view of a second exemplary embodiment of the free layer structure 106 of Figure 1. As shown, the second exemplary free layer structure 106 may include a tri-layer SAF 302 that is substantially similar to the tri-layer SAF 202 of figure 2. As such, SAF 302 may consist of an exchange layer 306 coupled between a first free ferromagnetic layer 304 and a second free ferromagnetic layer 308, and the first and second free ferromagnetic layers may be anti-ferromagnetically coupled through the exchange layer 306. In this configuration, the first free ferromagnetic layer 304 may have a first magnetic moment vector, the second free ferromagnetic layer 308 may have a second magnetic moment vector, and the SAF 302 may have a resultant magnetic moment vector based on the difference between the first and second magnetic moment vectors.

The second exemplary free layer structure 106 may then include a first biasing layer 310 and a second biasing layer 312, both of which may be substantially similar to the biasing layers 110 and 210. As shown, the first biasing layer 310 may be coupled to the first free ferromagnetic layer 304 of the SAF 302, and the second biasing layer 312 may be coupled to the second free ferromagnetic layer 308 of the SAF 302. As such, the first biasing layer 310 may impede a rotation of the first magnetic moment vector, and the second biasing layer 312 may impede a rotation of the second magnetic moment vector. In turn, the first and second biasing layers may impede a decoupling of the anti-ferromagnetic coupling of the SAF 302, thus extending the saturation field of the second exemplary free magnetic structure 106.

The first biasing layer 310 will preferably be weakly coupled to the first free ferromagnetic layer 304 and the second biasing layer 312 will preferably be weakly coupled to the second free ferromagnetic layer 308, such that the first and second biasing layers do not significantly alter the switching fields of the free ferromagnetic layers, and thus the switching field of the SAF 302. In a preferred example, the coupling strength between the first biasing layer 310 and the first free ferromagnetic layer 304 and the coupling strength between the second biasing layer 312 and the second free ferromagnetic layer 308 will be less than the anti-ferromagnetic coupling strength of the SAF 302 between the first free ferromagnetic layer 304 and the second free ferromagnetic layer 308. As above, these coupling strengths may be controlled by the material, processing, and/or dimensions of the biasing layers 310 and 312 and the SAF 302.

Figure 4 is a sectional view of a third exemplary embodiment of the free layer structure 106 of Figure 1. As shown, the third exemplary free layer structure 106 may include a tri-layer SAF 402 that is substantially similar to the tri-layer SAF 202 of figure 2 and tri-layer SAF 302 of Figure 3. As such, SAF 402 may consist of an exchange layer 406 coupled between a first free ferromagnetic layer 404 and a second free ferromagnetic layer 408, and the first and second free ferromagnetic layers may be anti-ferromagnetically coupled through the exchange layer 406. In this configuration, the first free ferromagnetic layer 404 may have a first magnetic moment vector, the second free ferromagnetic layer 408 may have a second magnetic moment vector, and the SAF 402 may have a resultant magnetic moment vector based on the difference between the first and second magnetic moment vectors.

The third exemplary free layer structure 106 may then include a biasing layer 410 which may be substantially similar to the biasing layers 110, 210, 310, and 312. Further, third exemplary free layer structure 106 may include non-magnetic layer 412 through which the biasing layer 410 is coupled to the SAF 402. Thus, as shown, the biasing layer 410 may be coupled through the non-magnetic layer 412 to the first free ferromagnetic layer 404 of the SAF 402. Alternatively, however, the biasing layer 410 may be coupled through the non-magnetic layer 412 to the second free ferromagnetic layer 408 of the SAF 402. As above, the biasing layer 410 may then impede a rotation of the first magnetic moment vector. In turn, the biasing layer 410 may impede a decoupling of the anti-ferromagnetic coupling of the SAF 402, thus extending the saturation field of the third exemplary free magnetic structure 106.

Further, as above, the biasing layer 410 will preferably be weakly coupled to the first free ferromagnetic layer 404, such that the biasing layer 210 does not significantly alter the switching field of the first free ferromagnetic layer 404, and thus the switching field of the SAF 402. In this respect, the non-magnetic layer 412 may control, and thus weaken, the coupling strength between the biasing layer 410 and the first free ferromagnetic layer 404.

The non-magnetic layer 412 may consist of almost any non-magnetic material, including tantalum, ruthenium, niobium, vanadium, osmium, rhodium, iridium, titanium, zirconium, hafnium, copper, silver, gold, platinum, chromium, molybdenum, tungsten, aluminum, magnesium, silicon, yttrium, cerium, palladium, and/or rhenium. In practical use, the use of the oxide, nitride, or carbide of the above-listed non-magnetic elements is more preferable for stably weakening the coupling. Further, the non-magnetic layer may have a thickness between 0.5 nm and 1.5 nm. Preferably, the SAF 402, the biasing layer 410, and the non-magnetic layer 412 will be designed such that the coupling strength between the biasing layer 410 and the first free ferromagnetic layer 404 will be less than the anti-ferromagnetic coupling strength of the SAF 402.

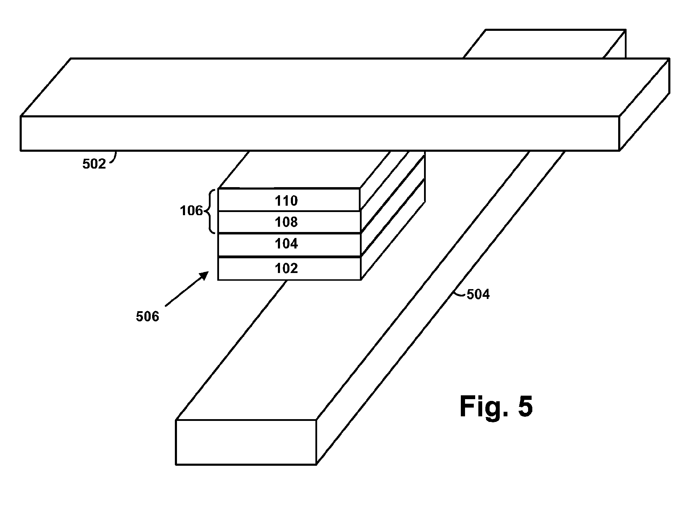

Figure 5 is a sectional view of a magnetic random access memory (MRAM) 500, according to an example of the present invention. As shown, the MRAM 500 may include at least one word line 502, at least one bit line 504, and at least one MRAM cell 506.

As shown, the word line 502 may arranged adjacent to and above the MRAM cell 506, and the bit line 504 may be arranged adjacent to and below the MRAM cell 506. In this respect, the word line 502 and bit line 504 may be separated from the MRAM cell 506 by insulative spacers (not shown). Further, the word line 504 may be arranged in a first direction and the bit line 506 may be arranged in a second direction, where the first direction and second direction are perpendicular. As such, the MRAM cell 506 may be positioned at an intersection of the word line 502 and the bit line 504. In this configuration, currents passing through the word line 502 and/or the bit line 506 create applied magnetic fields that may act on the MRAM cell 506, and data may be written to the MRAM cell 506 according to the toggle write method previously described.

The MRAM cell 506 will preferably be the magnetoresistive element 100 of figure 1. As such, the MRAM cell 506 may include any of the free magnetic structures 106 described herein, including the first, second, and third exemplary free magnetic structures. In this respect, the MRAM 500 may operate with a reduced error rate because of the improved operating window of the free magnetic structures 106.

It should be understood that the illustrated embodiments are examples only and should not be taken as limiting the scope of the present invention. The claims should not be read as limited to the described order or elements unless stated to that effect. Therefore, all embodiments that come within the scope and spirit of the following claims and equivalents thereto are claimed as the invention.

## Claims

1. A magnetoresistive element comprising:
a pinned magnetic structure;
a free magnetic structure; and
a spacer layer coupled between the pinned magnetic structure and the free magnetic structure,
wherein the free magnetic structure comprises:
a synthetic anti-ferromagnetic structure including two or more anti-ferromagnetically coupled ferromagnetic layers; and
a first biasing layer coupled to the synthetic anti-ferromagnetic structure, wherein the first biasing layer impedes a decoupling of the two or more anti-ferromagnetically coupled ferromagnetic layers.

2. The magnetoresistive element of claim 1, wherein the first biasing layer comprises an anti-ferromagnetic layer.

3. The magnetoresistive element of claim 1, wherein the first biasing layer is weakly coupled to the synthetic anti-ferromagnetic structure.

4. The magnetoresistive element of claim 1, wherein a coupling strength between the first biasing layer and the synthetic anti-ferromagnetic structure is less than an anti-ferromagnetic coupling strength of the synthetic anti-ferromagnetic structure.

5. The magnetoresistive element of claim 1, wherein the first biasing layer is selected from a group consisting of:
an iron manganese layer;
a nickel manganese layer; and
a platinum manganese layer.

6. The magnetoresistive element of claim 1, wherein the free magnetic structure further comprises:
a second biasing layer coupled to the synthetic anti-ferromagnetic structure, wherein the second biasing layer further impedes a decoupling of the two or more anti-ferromagnetically coupled ferromagnetic layers.

7. The magnetoresistive element of claim 1, wherein the free magnetic structure further comprises:
a non-magnetic layer coupled between the first biasing layer and the synthetic anti-ferromagnetic structure, wherein the non-magnetic layer controls a coupling strength between the first biasing layer and the synthetic anti-ferromagnetic structure.

8. The magnetoresistive element of claim 1, wherein the synthetic anti-ferromagnetic structure comprises:
a first free ferromagnetic layer having a first magnetic moment vector;
a second free ferromagnetic layer having a second magnetic moment vector; and
an exchange layer coupled between the first free ferromagnetic layer and the second free ferromagnetic layer,
wherein the first free ferromagnetic layer and the second free ferromagnetic layer are anti-ferromagnetically coupled through the exchange layer.

9. The magnetoresistive element of claim 8, wherein the first biasing layer is coupled to the first free ferromagnetic layer, and wherein the first biasing layer impedes a rotation of the first magnetic moment vector.

10. The magnetoresistive element of claim 9, wherein the free magnetic structure further comprises:
a second biasing layer coupled to the second free ferromagnetic layer, wherein the second biasing layer impedes a rotation of the second magnetic moment vector; and
a non-magnetic layer coupled between the first biasing layer and the first free ferromagnetic layer, wherein the non-magnetic layer controls a coupling strength between the first biasing layer and the first free ferromagnetic layer.
